Europäisches Patentamt

(19) European Patent Office

Office européen des brevets

(11) Publication number:

**0 175 489**
**B1**

(12) **EUROPEAN PATENT SPECIFICATION**

(45) Date of publication of patent specification: 03.01.90

(51) Int. Cl.⁵: **G 11 C 17/00**

(21) Application number: 85305914.5

(22) Date of filing: 20.08.85

(54) **An eprom device and method of manufacturing same.**

(30) Priority: 20.08.84 JP 171451/84

(43) Date of publication of application:
26.03.86 Bulletin 86/13

(45) Publication of the grant of the patent:
03.01.90 Bulletin 90/01

(84) Designated Contracting States:
DE FR GB

(56) References cited:

PATENT ABSTRACTS OF JAPAN, vol. 7, no. 214
(E-199)1359r, 21st September 1983; & JP-A-58
106 851 (NIPPON DENKI K.K.) 25-06-1983

PATENT ABSTRACTS OF JAPAN, vol. 6, no. 132
(E-119)1010r, 17th July 1982; & JP-A-57 59 364
(HITACHI SEISAKUSHO K.K.) 09-04-1982

(73) Proprietor: **Oki Electric Industry Company,
Limited**
7-12, Toranomon 1-chome Minato-ku
Tokyo 105 (JP)

(72) Inventor: **Okuaki, Hiroshi c/o Oki Electric
Industry Co. Ltd.**
7-12, Toranomon 1-chome
Minato-ku Tokyo 105 (JP)

(74) Representative: **Boydell, John Christopher et al
Stevens, Hewlett & Perkins 5 Quality Court
Chancery Lane**
London, WC2A 1HZ (GB)

## Description

The present invention relates to an erasable programmable read-only memory (hereinafter simply called EPROM) device of the type which can be erased by an ultra-violet (UV) ray and a manufacturing method thereof.

A well known example of such an EPROM device using a ceramic dual-in-line type package (hereinafter simply called ceramic package) is illustrated in Figures 1 to 3 of the accompanying drawings in which:—

Figure 1 is a perspective view of a known EPROM device;

Figure 2 is a cross sectional view along section line A—A of Figure 1; and

Figure 3 is a partially enlarged view of Figure 2.

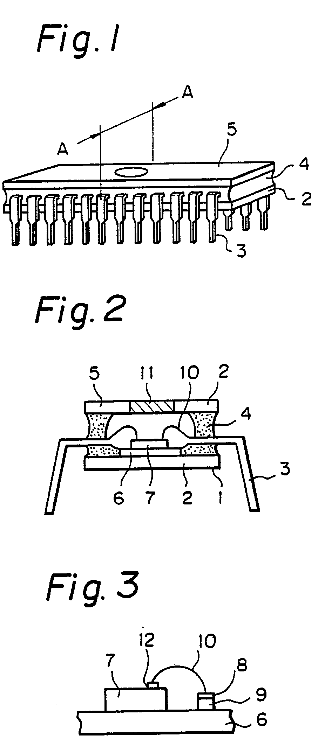

Referring to Figures 1 to 3, the known EPROM device comprises a ceramic header 1 having a base material 2, a plurality of leads 3 and a low temperature melting point glass 4. A ceramic cap 5 comprises the base material 2 and the glass 4. The base material 2 is made of alumina ($Al_2O_3$).

A memory element 7 and a ground die 9 whose head portion 8 is covered with evaporated aluminium, are bonded or mounted on a chip mounting portion 6 of the header 1. After wire-bonding with thin metal wires 10 made, for example, of aluminium between the memory element 7 and the head portion 8, the header 1 with the cap 5 thereon is passed through a sealing furnace set at the melting point temperature of the glass 4, for example, 400°C to 500°C, so as to seal the ceramic package by melting the glass 4, thereby forming the EPROM device. A window 11 through which an UV ray may pass into the memory element 7 is formed at the centre of the cap 5.

In the above described prior art construction the thin aluminium metal wire 10 which electrically connects an earth electrode pad 12 of the memory element 7 to the substrate of the memory element 7 through the chip mounting portion 6 cannot be used as a direct connector to the chip mounting portion 6 sintered with gold paste, because the sealing temperature is relatively high. Accordingly, the thin aluminium metal wire 10 must be relayed via the head portion 8 of the ground die 9 which is a piece of silicon, which can be troublesome in manufacture. Though the ceramic package is one of the most low-priced packages among the types of packages generally used for EPROM devices, it has further defects due to the high sealing temperature over that mentioned above. One is that it consumes much time in construction because gold wires cannot be used for wire-bonding. Another is that cracks can be caused on the package because the ceramic package is quite fragile against shock. Furthermore, the ceramic package is relatively heavy thereby restricting the package density on a printed circuit board.

Examples of a plastic mold type EPROM device for overcoming such defects have been proposed in Japanese application numbers 183085/1983 and 183086/1983.

However, they have still some defects mentioned below:—

(1) Since an UV ray permeable resin has not enough adhesive strength and water proof resistance, water moisture resistance as a package is not always sufficient.

Additionally, since the plastic package does not have enough resistance against thermal stress, the quality sometimes degrades during heat cycle testing.

(2) Since the resin used in the plastic package is rather expensive regardless of sufficient transmittancy of the UV ray, it is desired to save on the quantity to be used.

(3) The difference between the thermal expansion coefficient of sealing resin by which all packages are enclosed or base material (alumina) and that of the UV ray permeable resin sometimes results in generation of cracks on the UV ray permeable resin.

It is an object of the present invention to provide an EPROM device having a high moisture resistance and a manufacturing method thereof.

It is another object of the present invention to provide an EPROM device having a high reliability and a manufacturing method thereof.

It is still another object of the present invention to provide an EPROM device and a manufacturing method thereof which can be produced at a relatively low price.

According to a first aspect of the present invention, there is provided a method of manufacturing an EPROM device comprising the steps of: a) mounting an EPROM chip on a chip mounting portion on a lead frame; b) connecting each of the electrodes of said EPROM chip to a corresponding terminal portion of said lead frame with thin metal wire; c) dropping an UV ray permeable resin onto a surface of said EPROM chip; d) covering said dropped resin by means of a hollow cap, a head portion thereof being made of material through which UV rays may pass, so as to cause said resin to fill at least the space between a head portion of said hollow cap and the surface of said EPROM chip; e) hardening said resin by heating; f) filling the remaining portion within said cap with insulating resin so as to establish, with said UV ray permeable resin, a double layer structure; g) hardening said insulating resin by heating; and h) enclosing said cap with further insulating resin except for both said head portion of said cap and a part of said terminal portions of the lead frame.

According to a second aspect of the invention there is provided an EPROM device comprising: a) a lead frame having a chip mounting portion and a plurality of terminal portions thereon; b) an EPROM chip mounted on said chip mounting portion and connected to said terminal portions with thin metal wires; c) a hollow cap, a head portion thereof being made of a material through which UV rays may pass, said cap being situated on said lead frame so as to cover said EPROM chip and said thin metal wires; d) an UV ray permeable resin filling at least the space between said head portion of the hollow cap and a main surface of said EPROM chip; e) insulating resin filling the remaining portion within said cap so as to establish, with said UV ray permeable resin, a double layer structure; and f) further insulating resin for enclosing said cap except for both said head portion thereof and a part of said terminal portions of said lead frame.

In an embodiment said hollow cap is so constituted that an edge portion thereof which is situated opposite to said head portion is formed with an L shaped flange which extends outwardly in a direction parallel to said lead frame.

In order that the invention may be better understood, two embodiments thereof will now be described by way of example only and with reference to the accompanying drawings in which:—

Figure 1 is a perspective view of a known EPROM device;

Figure 2 is a cross-sectional view along section line A—A of Figure 1;

Figure 3 is a partially enlarged view of Figure 2;

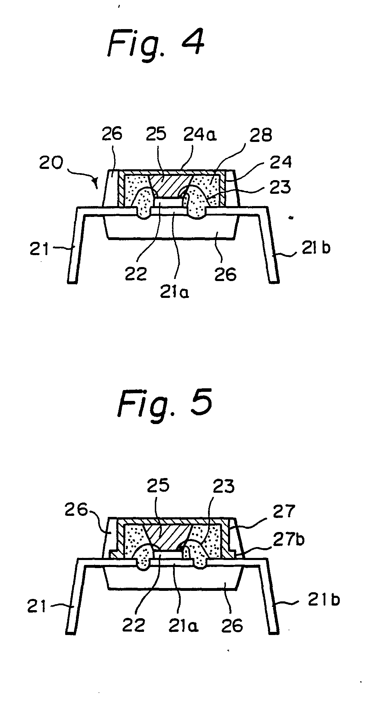

Figure 4 is a cross-sectional view illustrating an embodiment of an EPROM device in accordance with the invention;

Figure 5 is a cross-sectional view illustrating another embodiment of an EPROM device in accordance with the invention; and

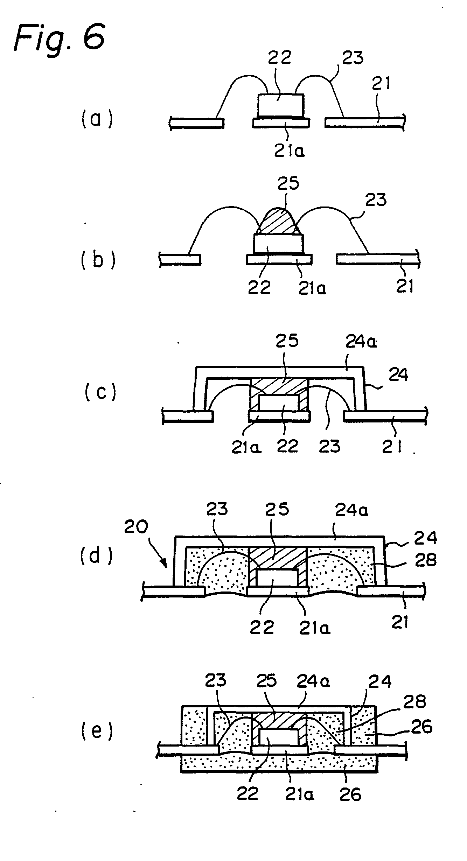

Figure 6(a) to Figure 6(e) are cross-sectional views illustrating the manufacturing steps of an EPROM device in accordance with the invention.

Referring to Figure 4, the reference numeral 20 denotes an embodiment of the invention, whereas the numeral 21 denotes a lead frame.

The lead frame 21 is made of metal plate having a chip mounting portion 21a and a plurality of terminal portions 21b thereon constituting a wiring pattern. An EPROM chip 22 is mounted on the chip mounting portion 21a and the electrodes formed on the surface of the chip 22 are connected to the terminal portions 21b of the lead frame 21 with thin metal wires 23 made, for example, of aluminium or gold. A hollow cap 24 is situated on the surface of the lead frame 21, covering the joint portion between the thin metal wires 23 and the terminal portions 21b including the chip 22.

The head portion 24a facing the EPROM chip surface to which an UV ray is exposed must be made of UV ray permeable material such as quartz or alumina. However, it is better to construct the whole hollow cap 24 of the same material such as alumina, quartz or UV ray permeable material to avoid complexity in construction.

Within the hollow cap 24, there is provided an UV ray permeability resin 25 in the space between the chip 22 or the chip mounting portion 21a and the head portion 24a of the hollow cap 24. An insulating resin 28 fills around the resin 25, the chip 22, the chip mounting portion 21a and the thin metal wire 23 so as to form a double layer structure operable to protect the EPROM chip 22 against outside moisture and impurity ions (electrode corrosive ions). Accordingly, the UV ray exposing surface of the EPROM chip 22 is covered with the resin 25.

The resin 25 only needs the property whereby it is capable of transmitting UV rays therethrough, because the cap 24 itself shuts out harmful outside atmosphere including mechanical stress and protects the EPROM chip 22. Silicone resin such as JCR-6122 (a commercial name by Torey, Japan) can be used, for example. On the other hand, silicone resin such as JCR-6110 (a commercial name by Torey, Japan) or epoxy resin is preferable as the insulating resin 28 because of its high stability.

The EPROM device 20 includes a receptacle 26 made of synthetic resin which encloses the cap 24 except for the outer surface of the head portion 24a.

Thermosetting epoxy resin (for use of semiconductor as filler) is preferable as a second insulating resin (synthetic resin) which forms the receptacle 26 because of its good adhesion to alumina or quartz.

Figure 5 illustrates another embodiment of the EPROM device according to the invention, wherein like reference characters denote like parts. Accordingly, only different parts will be explained in detail hereinafter.

A hollow cap 27 shown in Figure 5 is so constituted that the opening which touches the terminal portions 21b has "L" shaped portion 27b at the edge thereof substantially parallel to an outer lead and extending in the opposite direction to the EPROM chip 22.

Since this construction makes the joint length longer between the hollow cap 27 and the receptacle 26 which sometimes acts as an entry path to introduce the harmful external atmosphere, especially moisture, the entry path to the EPROM chip 22 becomes longer, thereby preventing not only characteristic degradation of the EPROM chip 22 caused by moisture but also release of the cap 27 from the receptacle 26.

As the EPROM device 20 is so constituted that the first insulating resin 28 enclosing the EPROM chip 22 is not made of UV ray permeable resin but instead is made of insulating resin, it results in a rather lower price in comparison with the prior EPROM device made of ceramic, because the resin itself is low-priced.

Additionally, since the sealing temperature at which the EPROM chip 22 is sealed is low, the thermal stress on the EPROM chip 22 is reduced, which makes it possible to use thin metal wires 23 preferable as high speed wire-bonding.

In the prior ceramic package, two-dimensional alloy is formed by reacting the aluminium of the surface electrode of the EPROM chip 22 with the thin metal wires 23 due to the high temperature sealing, which causes the wiring resistance value to be high. To avoid this problem, aluminium wires have been used as the thin metal wires 23.

However, since this invention utilises sealing with synthetic resin which does not require high temperature, the alloying reaction is suppressed thereby enabling high speed wire-bonding using gold wires.

Furthermore, since the chip mounting portion 21a of the well known lead frame 21 which is formed by etching or stamping of a metal plate can be directly connected to the edge portion of inner leads, a ground die becomes unnecessary thereby saving a troublesome installation job.

Additionally, since the EPROM device according to the invention is relatively lighter than that constituted by a ceramic package, package density increases on printed circuit boards and no cracks occur on the package.

Figure 6(a) to Figure 6(e) show the manufacturing steps of the EPROM device according to the present invention.

Firstly as shown in Figure 6(a), the EPROM chip 22 is loaded on the chip mounting portion 21a of the lead frame 21 and mounted by die-bonding with Ag paste. Then, the electrodes formed on the surface of the EPROM 22 are wire-bonded with thin metal wires 23 to the terminal portion 21b of the lead frame 21.

Secondly as shown in Figure 3(b), the UV ray permeable resin 25 is dipped onto the surface of the EPROM chip 22. Then, as shown in Figure 3(c), the hollow cap 24 made of, for example, alumina is placed in position, thereby filling the gap between the surface of the EPROM chip 22 and the head portion 24a of the cap 24 with the resin 25. The cap 24 is secured to the EPROM chip 22. The resin 25 is next hardened by heating.

Thirdly as shown in Figure 3(d), a first batch of insulating resin is provided to fill around the EPROM chip 22, the thin metal wires 23 and the chip mounting portion 21a. The filling is carried out by potting with the EPROM device upside down.

Then, after hardening the resin 28 by heating, sealing is performed by introducing a second batch of insulating resin to form the receptacle 26, as shown in Figure 3(e).

The EPROM device 20 shown in Figure 4 has now been completed.

**Claims**

1. A method of manufacturing an EPROM device comprising the steps of:

a) mounting an EPROM chip (22) on a chip mounting portion (21a) on a lead frame (21);

b) connecting each of the electrodes of said EPROM chip to a corresponding terminal portion (21b) of said lead frame (21) with thin metal wire (23);

c) dropping an UV ray permeable resin (25) onto a surface of said EPROM chip;

d) covering said dropped resin by means of a hollow cap (24), a head portion (24a) thereof being made of a material through which UV rays may pass, so as to cause said resin (25) to fill at least the space between said head portion of said hollow cap and the surface of said EPROM chip;

e) hardening said resin (25) by heating;

f) filling the remaining portion within said cap with insulating resin (28) so as to establish, with said UV ray permeable resin (25), a double layer structure;

g) hardening said insulating resin (28) by heating; and

h) enclosing said cap (24) with further insulating resin (26) except for both said head portion of said cap and a part of said terminal portions of the lead frame.

2. An EPROM device comprising:

a) a lead frame (21) having a chip mounting portion (21a) and a plurality of terminal portions (21b) thereon;

b) an EPROM chip (22) mounted on said chip mounting portion (21a) and connected to said terminal portions (21b) with thin metal wires (23);

c) a hollow cap (24), a head portion (24a) thereof being made of a material through which UV rays may pass, said cap being situated on said lead frame so as to cover said EPROM chip and said thin metal wires;

d) un UV ray permeable resin (25) filling at least the space between said head portion of the hollow cap and a main surface of said EPROM chip;

e) insulating resin (28) filling the remaining portion within said cap so as to establish, with said UV ray permeable resin (25), a double layer structure; and

f) further insulating resin (26) for enclosing said cap (24) except for both said head portion thereof and a part of said terminal portions of said lead frame.

3. An EPROM device as claimed in claim 2, wherein said hollow cap (24) is so constituted that an edge portion (27) thereof which is situated opposite to said head portion is formed with an L shaped flange (27b) which extends outwardly in a direction parallel to said lead frame.

**Patentansprüche**

1. Verfahren zum Herstellen einer EPROM-Vorrichtung mit folgenden Schritten:

a) Aufbringen eines EPROM-Chips (22) auf einem Chip-Aufbringungabschnitt (21a) auf einem Zuleitungs-Rahmen (21),

b) Verbinden einer jeden Elektrode des EPROM-Chip mit einem entsprechenden Anschlußabschnitt (21b) des Zuleitungs-Rahmens (21) mit einem dünnen Metalldraht (23),

c) Auftropfen eines UV-Strahlen-durchlässigen Harzes (25) auf eine Oberfläche des EPROM-Chips,

d) Bedecken des aufgetropften Harzes mittels einer hohlen Kappe (24), von der ein Kopfabschnitt (24a) aus einem Material besteht, durch das UV-Strahlen hindurchgelangen können, derart, daß das Harz (25) zumindest den Raum zwischen dem Kopfabschnitt der hohlen Kappe und der Oberfläche des EPROM-Chips bedeckt,

e) Härten des Harzes (25) durch Erhitzen,

f) Ausfüllen des verbleibenden Abschnitts innerhalb der Kappe mit isolierendem Harz (28), um so mit dem UV-Strahlen-durchlässigen Harz (25) eine Doppelschichtstruktur zu schaffen,

g) Härten des isolierenden Harzes (28) durch Erhitzen, und

h) Umschließen der Kappe (24) mittels weiterem isolierendem Harz (26) mit Ausnahme sowohl des Kopfabschnitts der Kappe und einem Teil der Anschlußabschnitte des Zuleitungs-Rahmens.

2. EPROM-Vorrichtung mit

a) einem Zuleitungs-Rahmen (21) mit einem Chip-Aufbringungsabschnitt (21a) und einer Vielzahl von Anschlußabschnitten (21b),

b) einem EPROM-Chip (22), das auf dem Chip-Aufbringungsabschnitt (21a) aufgebracht ist und mit den Anschlußabschnitten (21b) mittels dünner Metalldrähte (23) verbunden ist,

c) einer hohlen Kappe (24), von der ein Kopfabschnitt (24a) aus einem Material besteht, durch das hindurch UV-Strahlen gelangen können, wobei die Kappe auf dem Zuleitungs-Rahmen so angeordnet ist, daß sie das EPROM-Chip und die dünnen Metalldrähte abdeckt,

d) einem UV-Strahlen-durchlässigen Harz (25), welches zumindest den Raum zwischen dem Kopfabschnitt der hohlen Kappe und einer Hauptoberfläche des EPROM-Chips ausfüllt,

e) einem isolierenden Harz (28), welches den verbleibenden Abschnitt innerhalb der Kappe ausfüllt, so daß zusammen mit dem UV-Strahlen-durchlässigen.Harz (25) eine Doppelschichtstruktur geschaffen wird, und

f) weiterem isolierendem Harz (26) zum Umschließen der Kappe (24) mit Ausnahme sowohl deren Kopfabschnitt als auch einem Teil der Anschlußabschnitte des Zuleitungs-Rahmens.

3. EPROM-Vorrichtung nach Anspruch 2, wobei die hohle Kappe (24) so ausgebildet ist, daß ein Kantenabschnitt (27) derselben, der entgegengesetzt zum Kopfabschnitt angeordnet ist, mit einem L-förmigen Flansch (27b) ausgebildet ist, der sich nach außen in einer Richtung parallel zum Zuleitungs-Rahmen erstreckt.

**Revendications**

1. Procédé de production d'un dispositif de mémoire morte programmable effaçable (EPROM), comprenant les étapes consistant:

a) à monter une puce EPROM (22) sur une portion de montage de puce (21a) présente sur un bâti conducteur (21);

b) à relier chacune des électrodes de ladite puce EPROM à une portion terminale correspondante (21b) dudit bâti conducteur (21) au moyen d'un fil métallique mince (23);

c) à faire tomber goutte à goutte une résine (25) perméable aux rayons UV sur une surface de ladite puce EPROM;

d) à couvrir ladite résine coulée goutte à goutte au moyen d'un couvercle creux (24), une portion supérieure (24a) de ce couvercle étant constituée d'une matière à travers laquelle les rayons UV peuvent passer, de manière à amener ladite résine (25) à remplir au moins l'espace entre ladite portion supérieure dudit couvercle creux et la surface de ladite puce EPROM;

e) à faire durcir ladite résine (25) par chauffage;

f) à remplir la portion restante à l'intérieure dudit couvercle avec une résine isolante (28) de manière à produire, avec ladite résine (25) perméable aux rayons UV, une structure à deux couches;

g) à faire durcir ladite résine isolante (28) par chauffage; et

h) à envelopper ledit couvercle (24) avec une quantité supplémentaire de résine isolante (26), excepté la portion supérieure dudit couvercle et une partie des portions terminales du bâti conducteur.

2. Dispositif EPROM comprenant:

a) un bâti conducteur (21) comprenant une portion (21a) de montage de puce et plusieurs portions terminales (21b);

b) une puce EPROM (22) montée sur ladite portion (21a) de montage de puce et reliée auxdites portions terminales (21b) au moyen de fils métalliques minces (23);·

c) un couvercle creux (24), dont une portion supérieure (24a) est constituée d'une matière à travers laquelle les rayons UV peuvent passer, ledit couvercle étant placé sur ledit bâti conducteur de manière à recouvrir ladite puce EPROM et lesdits fils métalliques minces;

d) une résine (25) perméable aux rayons UV remplissant au moins l'espace entre ladite portion supérieure du couvercle creux et une espace principale de ladite puce EPROM;

e) une résine isolante (28) remplissant la portion restante à l'intérieur dudit couvercle de manière à produire, avec ladite résine (25) perméable aux rayons UV, une structure à deux couches; et

f) une quantité supplémentaire de résine isolante (26) destinée à envelopper ledit couvercle (24), excepté sa portion supérieure et une partie desdites portions terminales dudit bâti conducteur.

3. Dispositif EPROM suivant la revendication 2, dans lequel le couvercle creux (24) présente une configuration telle qu'une portion latérale (27) de ce couvercle, qui est située à l'opposé de ladite portion supérieure, soit formée avec un rebord en forme de L (27b) qui s'étend vers l'extérieur dans une direction parallèle audit bâti conducteur.

## Fig. 1

## Fig. 2

## Fig. 3

1

# Fig. 4

# Fig. 5

# Fig. 6

(a)

22    23    21

21a

(b)

25    23

22    21a    21

(c)

25    24a    24

21a    22    23    21

(d)

23    25    24a

20    24

28

22    21a    21

(e)

23    25    24a    24

28

26

22    21a    26